# EUROPÄISCHE PATENTSCHRIFT

(11) **EP 1 342 270 B1**
(45) Veröffentlichungstag und Bekanntmachung des Hinweises auf die Patenterteilung: **03.10.2007**
(21) Anmeldenummer: 01999005.0
(22) Anmeldetag: 22.10.2001
(51) Int. Cl.: H01L 27/115, H01L 21/8247

(54) **FLASH-EEPROM-SPEICHERANORDNUNG SOWIE DAZUGEHÖRIGES HERSTELLUNGSVERFAHREN**
FLASH-EEPROM STORAGE DEVICE AND CORRESPONDING PRODUCTION METHOD
SYSTEME DE MEMOIRE EEPROM FLASH ET PROCEDE DE PRODUCTION CORRESPONDANT

(30) Priorität: 28.11.2000 DE 10058948
(43) Veröffentlichungstag der Anmeldung: 10.09.2003
(73) Patentinhaber: Infineon Technologies AG, 81669 München (DE)
(72) Erfinder: SHUM, Danny, Poughkeepsie, NY 12601 (US); TEMPEL, Georg, B-1933 Sterrebeek (BE)
(74) Vertreter: Karl, Frank
(86) Internationale Anmeldenummer: PCT/DE2001/004008
(87) Internationale Veröffentlichungsnummer: WO 2002/045170

(56) Entgegenhaltungen:
- FR-A- 2 375 692
- US-A- 5 760 437
- PATENT ABSTRACTS OF JAPAN vol. 1996, no. 12, 26. Dezember 1996 (1996-12-26) & JP 08 204159 A (SONY CORP), 9. August 1996 (1996-08-09)

## Beschreibung

Die vorliegende Erfindung bezieht sich auf eine Halbleiterschaltungsanordnung sowie ein dazugehöriges Herstellungsverfahren und insbesondere auf einen FLASH-EPROM-Speicher mit SNOR-Architektur, bei der jeweilige Source- und Drainleitungen selektiv angesteuert werden können.

Zum Speichern von größeren Datenmengen werden derzeit von Rechnereinheiten bzw. Computern in der Regel magnetische Plattenlaufwerke benutzt. Derartige Plattenlaufwerke benötigen jedoch einen relativ großen Platz und weisen eine Vielzahl von beweglichen Teilen auf. Folglich sind sie störanfällig und besitzen einen beträchtlichen Stromverbrauch. Darüber hinaus werden die zukünftigen Rechnereinheiten bzw. Computer sowie andere digitale Geräte wie beispielsweise digitale Kameras, Musikwiedergabegeräte oder Palm-Geräte bzw. PDAs immer kleiner, weshalb herkömmliche mechanische Speichereinrichtungen ungeeignet sind.

Als Alternative zu derartigen herkömmlichen mechanischen Speichereinrichtungen haben sich in letzter Zeit nicht flüchtige Halbleiterspeichereinrichtungen immer mehr durchgesetzt, wie sie beispielsweise als FLASH-Speicher, E²PROM, EPROM und dergleichen bekannt sind. Als wichtigste Vertreter derartiger elektrisch löschbarer und elektrisch programmierbarer Speichereinrichtungen sind die sogenannten NAND- sowie NOR-Halbleiterspeichereinrichtungen bekannt. In beiden Halbleiterspeichereinrichtungen weisen die Speicherzellen sogenannte Eintransistor-Speicherzellen auf, wobei üblicherweise in einem aktiven Gebiet eines Halbleitersubstrats ein Draingebiet und ein Sourcegebiet ausgebildet sind und sich über dem dazwischen liegenden Kanalabschnitt eine isolierte ladungsspeichernde Schicht befindet.

Während in NAND-Halbleiterschaltungsanordnungen eine Vielzahl von Schaltelementen seriell miteinander verbunden sind und über ein gemeinsames Auswahlgatter bzw. einen Auswahltransistor angesteuert werden, sind die jeweiligen Schaltelemente in NOR-Halbleiter-Schaltangsanordnungen parallel bzw. matrixförmig organisiert, wodurch jedes Schaltelement einzeln ausgewählt werden kann.

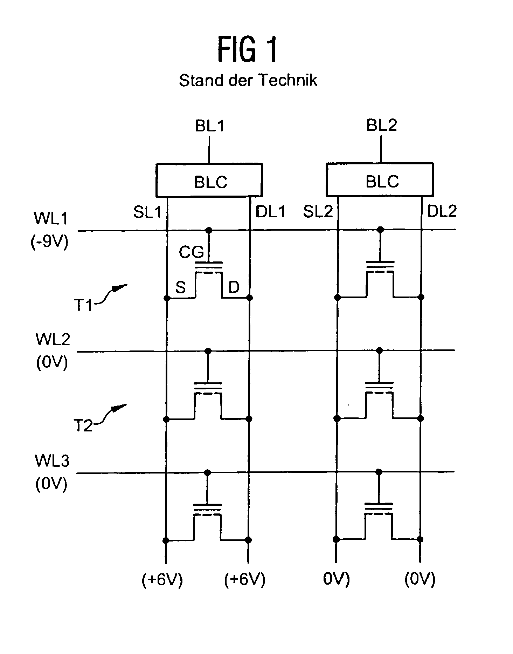

Figur 1 zeigt eine vereinfachte Darstellung einer herkömmlichen SNOR-Halbleiter-Schaltungsanordnung (selective NOR), bei der im Gegensatz zur NOR-Halbleiter-Schaltungsanordnung mit "common source"-Architektur die einzelnen Schaltelemente T1, T2, ... selektiv über eine jeweilige Sourceleitung SL1, SL2, ... und über eine jeweilige Drainleitung DL1, DL2, ... angesteuert werden. Diese selektive Ansteuerung wird beispielsweise über jeweilige Bitleitungssteuerungen BLC durchgeführt, welche sozusagen die gemeinsamen Bitleitungen BL1, BL2, ... realisieren. Auf diese Weise können weitere "shrinks" bzw. eine weitergehende Integration der Halbleiter-Schaltungsanordnung durchgeführt werden, da die SNOR-Architektur nicht auf eine vorbestimmte Mindest-Zelltransistorlänge bzw. Kanallänge angewiesen ist.

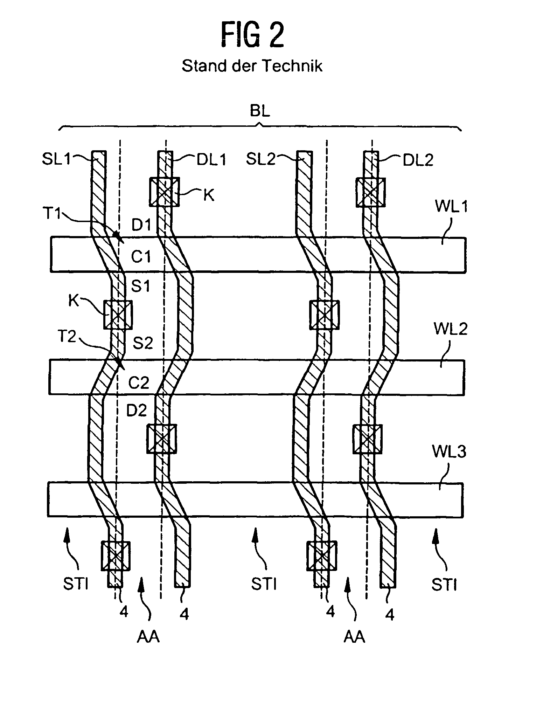

Figur 2 zeigt eine vereinfachte Darstellung eines herkömmlichen Layouts der SNOR-Halbleiterschaltungsanordnung gemäß Figur 1. Gemäß Figur 2 werden die Schaltelemente T1, T2, ... in aktiven Bereichen AA eines Halbleitersubstrats ausgebildet, die eine im Wesentlichen gerade streifenförmige Struktur aufweisen. Die Vielzahl von spaltenweise angeordneten streifenförmigen aktiven Bereiche AA werden zeilenweise von ebenfalls streifenförmig ausgebildeten Schichtstapeln überlagert, wobei eine oberste Schicht eine Steuerschicht bzw. Wortleitung WL1 bis WL3 der Schaltelemente T1, T2, ... darstellt. Jeder Kreuzungspunkt bzw. Überlappungsbereich eines derartigen streifenförmigen aktiven Bereiches AA mit einer streifenförmig ausgebildeten Wortleitung WL1 bis WL3 stellt somit eine Vielzahl von Schaltelementen T dar. Zum Kontaktieren von jeweiligen Draingebieten D und Sourcegebieten S sind Kontakte K notwendig, die üblicherweise im aktiven Bereich AA ausgebildet sind, oftmals jedoch auch in ein angrenzendes Isolationsgebiet STI (shallow trench isolation) reichen können. In einer weiteren darüber liegenden Schicht, die vorzugsweise eine erste Metallisierungsschicht darstellt, befinden sich nunmehr die Sourceleitungen SL1, SL2, ... sowie die Drainleitungen DL1, DL2, ... für die jeweiligen Bitleitungen BL. Die Drainleitungen stehen hierbei über entsprechende Kontakte K mit den dazugehörigen Draingebieten D des aktiven Bereichs in Verbindung, wobei in gleicher Weise die Sourceleitungen SL1 über entsprechende Kontakte mit den dazugehörigen Sourcegebieten in Verbindung stehen.

Nachteilig ist jedoch bei einem derartigen herkömmlichen Layout, dass auf Grund der zusätzlichen Sourceleitungen im Vergleich zu einer "common source"-Architektur eine mehr als doppelt so intensive Metallisierung vorliegt, was einen begrenzenden Faktor für eine weitergehende Integration bzw. weitere Shrinks darstellt. Darüber hinaus ergeben sich insbesondere bei mäanderförmig ausgestalteten Source- und Drainleitungen sogenannte Lithografie-Artefakte, die zu einer Verjüngung bis hin zu Unterbrechungen der jeweiligen Leitungen führen können.

Aus der den Oberbegriff des Patentanspruchs 1 bildenden Druckschrift US-A-5760437 ist eine Halbleiterschaltungsanordnung mit einer Vielzahl von in einem Halbleitersubstrat ausgebildeten matrixförmig angeordneten Schaltelementen, einer Vielzahl von im Wesentlichen geraden Wortleitungen zum zeilenweisen Ansteuern der Schaltelemente, und einer Vielzahl von im Wesentlichen geraden Bitleitungen zum spaltenweisen Ansteuern der Schaltelemente bekannt, wobei die Wortleitungen im Wesentlichen durch eine Steuerschicht der Schaltelemente ausgebildet werden. Die Bitleitungen weisen jeweils eine Sourceleitung und eine Drainleitung auf, die eine selektive Ansteuerung von jeweiligen Source- und Draingebieten des Schaltelements ermöglichen, die in im Wesentlichen geraden aktiven Bereichen des Halbleitersubstrats voneinander beabstandet ausgebildet sind. Zum Anschließen der Source- und Draingebiete an die jeweiligen Sourceleitungen und Drainleitungen sind eine Vielzahl von zwischen den Wortleitungen liegenden elektrisch leitenden Anschlusselementen vorgesehen, welche jedoch Nasen oder Vorsprünge der Bitleitungen darstellen.

Gemäß einer weiteren nicht dargestellten Halbleiterschaltungsanordnung können auch die aktiven Bereiche AA sogenannte Nasen bzw. Vorsprünge aufweisen, wodurch sich die Layoutanforderungen für die Source- und Drainleitungen entspannen lassen. Da jedoch nunmehr im aktiven Bereich ein Vorsprung bzw. eine Nase auszubilden ist ergeben sich wiederum in diesem Bereich Probleme insbesondere bei der lithografischen Realisierung.

Der Erfindung liegt daher die Aufgabe zu Grunde eine Halbleiterschaltungsanordnung sowie ein zugehöriges Herstellungsverfahren zu schaffen, bei dem sich eine weitere Integration auf einfache Weise realisieren lässt.

Erfindungsgemäß wird diese Aufgabe hinsichtlich der Anordnung durch die Merkmale des Patentanspruchs 1 und hinsichtlich des Verfahrens durch die Maßnahmen des Patentanspruchs 9 gelöst.

Insbesondere durch die Verwendung einer Vielzahl von elektrisch leitenden Anschlussstreifen zum Anschließen der Source-und Draingebiete an die jeweiligen Sourceleitungen und Drainleitungen, wobei die Anschlussstreifen aus einer zweiten leitenden Schicht bestehen und zwischen den Wortleitungen und unter den Bitleitungen liegen sowie die Source- und Draingebiete an der Oberfläche des Halbleitersubstrats unmittelbar berühren, ergibt sich sowohl für die aktiven Bereiche als auch für die Source- und Drainleitungen ein optimales Layout, nämlich eine im Wesentlichen geradlinige Streifenstruktur, wodurch Probleme bei der Lithografie verhindert werden können. Da die Anschlussstreifen ferner durch Abscheiden und Rückbilden unmittelbar zwischen den Wortleitungen ausgebildet werden können, erhält man ferner eine weitergehende Verkleinerung der Zellfläche für ein Schaltelement.

Vorzugsweise weist der Anschlussstreifen ein insitu-dotiertes Polysilizium auf, wodurch sich eine besonders gute Kontaktierung der Source- und Draingebiete realisieren lässt und auf Grund der hervorragenden Fülleigenschaften die Zwischenräume zwischen den Wortleitungen optimal ausgefüllt werden.

Ferner können die Anschlussstreifen ein siliziertes Polysilizium aufweisen, wodurch die Leitfähigkeit weiter verbessert wird und sich die Zugriffszeiten auf das Schaltelement weiter verbessern.

Vorzugsweise wird als Schaltelement eine nichtflüchtige Eintransistor-Speicherzelle verwendet, wodurch man einen nichtflüchtigen Speicher mit maximaler Integrationsdichte erhält.

Vorzugsweise besitzen die Wortleitungen eine isolierende Schutzschicht, die als Ätzstoppschicht und als CMP-Detektionsschicht wirkt, wodurch ein Rückbilden der zunächst ganzflächig abgeschiedenen Anschlussstreifenschicht sehr exakt erfolgen kann. Als Schutzschicht wird beispielsweise ein Siliziumnitrid verwendet, welches diese Funktionen als Ätzstoppschicht und CMP-Detektionsschicht erfüllt.

Vorzugsweise werden die im Wesentlichen geraden aktiven Bereiche mittels flacher Grabenisolierung im Halbleitersubstrat ausgebildet, wodurch sich auch bei sehr kleinen Strukturgrößen eine zuverlässige Isolierung zwischen den einzelnen Schaltelementen realisieren lässt.

In den weiteren Unteransprüchen sind weitere vorteilhafte Ausgestaltungen der Erfindung gekennzeichnet.

Die Erfindung wird nachstehend anhand eines bevorzugten Ausführungsbeispiels unter Bezugnahme auf die Zeichnung näher beschrieben.

Es zeigen:
- Figur 1: ein vereinfachtes Ersatzschaltbild einer herkömmlichen SNOR-Halbleiterschaltungsanordnung;
- Figur 2: eine vereinfachte Draufsicht der herkömmlichen SNOR-Halbleiterschaltungsanordnung gemäß Figur 1;
- Figur 3: eine vereinfachte Schnittansicht der erfindungsgemäßen SNOR-Halbleiterschaltungsanordnung;
- Figuren 4 und 5: eine vereinfachte Draufsicht von ersten Herstellungsschritten zur Realisierung der erfindungsgemäßen SNOR-Halbleiterschaltungsanordnung;
- Figur 6: eine zum Ausbilden der erfindungsgemäßen Anschlussstreifen benötigte Maske;
- Figuren 7 und 8: eine vereinfachte Draufsicht von weiteren Herstellungsschritten zur Realisierung der erfindungsgemäßen SNOR-Halbleiterschaltungsanordnung; und
- Figur 9: eine vereinfachte Schnittansicht der erfindungsgemäßen SNOR-Halbleiterschaltungsanordnung gemäß einem Schnitt II-II' in Figur 8.

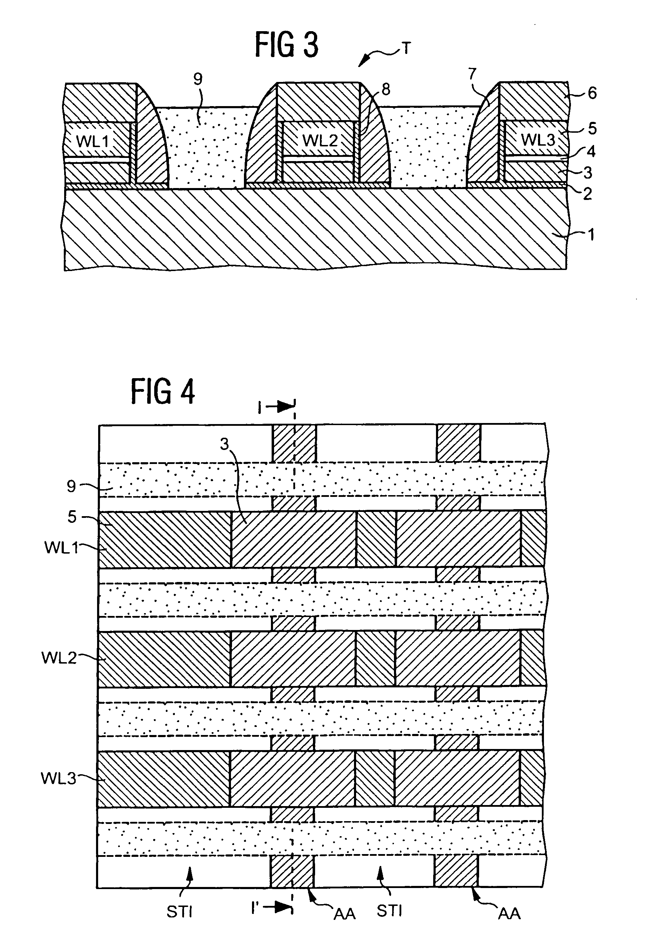

Figur 3 zeigt eine vereinfachte Schnittansicht der erfindungsgemäßen SNOR-Halbleiterschaltungsanordnung gemäß einem Schnitt I-I in Figur 4.

Zur Herstellung der in Figur 3 dargestellten SNOR-Halbleiterschaltungsanordnung werden zunächst die nachfolgend beschriebenen jedoch nicht näher dargestellten Herstellungsschritte durchgeführt. Zunächst werden in einem Halbleitersubstrat 1 (z.B. Si) im Wesentlichen gerade aktive Bereiche AA beispielsweise mittels Grabenisolierung ausgebildet, wobei insbesondere eine flache Grabenisolierung (shallow trench isolation, STI) Verwendung findet. Da die aktiven Bereiche AA im Wesentlichen gerade ausgebildet sind, ergeben sich bei der Lithografie keinerlei Probleme auf Grund von Kanten oder komplizierten geometrischen Formen.

Anschließend wird auf der Waferoberfläche bzw. im Bereich der aktiven Bereiche AA eine erste Isolierschicht 2 ausgebildet, die vorzugsweise eine Tunneloxidschicht darstellt und als thermisches Siliziumdioxid ausgebildet wird. Die erste Isolierschicht 2 kann jedoch in gleicher Weise auch mittels eines Abscheideverfahrens oder anderweitig ausgebildet werden. Im bevorzugten Ausführungsbeispiel besteht ein Schaltelement T aus einer Eintransistor-Speicherzelle, weshalb in einem nachfolgenden Schritt eine ladungsspeichernde Schicht 3 vorzugsweise durch Abscheiden eines Polysiliziums als "Floating Gate" ausgebildet wird. Die Erfindung ist jedoch nicht auf eine derartige elektrisch leitende ladungsspeichernde Schicht beschränkt sondern umfasst in gleicher Weise auch elektrisch nicht leitende ladungsspeichernde Schichten, wie sie beispielsweise in sogenannten SONOS-Zellen verwendet werden.

Zur Realisierung von elektrisch voneinander getrennten ladungsspeichernden Schichten kann nunmehr in einem weiteren Herstellungsschritt ein erstes Strukturieren der ladungsspeichernden Schicht 3 erfolgen, wobei zunächst streifenförmige ladungsspeichernde Schichten in Richtung der aktiven Bereiche AA ausgebildet werden. Nach diesem Strukturierungsschritt, der üblicherweise mittels fotolithografischer Prozesse durchgeführt wird, werden in nachfolgenden Herstellungsschritten eine zweite Isolierschicht 4, eine erste leitende Schicht 5 und eine Schutzschicht 6 auf dem Wafer abgeschieden. Als zweite Isolierschicht 4 wird vorzugsweise eine Schichtenfolge aus Oxid/Nitrid/Oxid (ONO) abgeschieden, wobei prinzipiell auch andere dielektrische isolierende Schichten verwendet werden können. Als erste leitende Schicht 5 wird beispielsweise eine weitere hochdotierte elektrisch leitende Polysiliziumschicht abgeschieden, die eine spätere Wortleitung realisiert. Alternativ können auch niederohmiges Polyzid oder metallische Wortleitungen verwendet werden. Als Schutzschicht 6 (cap layer) wird vorzugsweise eine Siliziumnitrid-Schicht verwendet, die sich bei späteren Herstellungsschritten besonders günstig als Ätzstoppschicht und CMP-Detektionsschicht zum Erfassen einer jeweiligen Rückbildungstiefe eignet.

In einem nachfolgenden Herstellungsschritt werden unter Verwendung eines (nicht dargestellten) Resists mittels herkömmlicher Lithografie im Wesentlichen gerade Wortleitungsstapel durch Strukturieren der Schutzschicht 6, der ersten leitenden Schicht 5 und der zweiten Isolierschicht 4 sowie der ladungsspeichernden Schicht 3 ausgebildet. Genauer gesagt wird zunächst die Schutzschicht 6 unter Verwendung des Resists trocken geätzt und anschließend der Resist entfernt. In einem weiteren Trockenätzschritt wird die erste leitende Schicht 5 selektiv zur zweiten Isolierschicht 4 vorzugsweise durch Trockenätzen unter Verwendung der Schutzschicht 6 als Maske geätzt, und nachfolgend in gleicher Weise die zweite Isolierschicht 4 sowie die ladungsspeichernde Schicht 3 selektiv zur ersten Isolierschicht 2 trocken geätzt. Abschließend erfolgt eine Nachbehandlung des geätzten Wortleitungsstapels, wobei beispielsweise Polymere entfernt werden und die Waferoberfläche gereinigt wird.

In einem optionalen zusätzlichen Herstellungsschritt können an den Seitenwänden Seitenisolierschichten 8 vorzugsweise als Oxid ausgebildet werden, wobei vorzugsweise eine thermische Oxidation durchgeführt wird. Anschließend werden Source- und Draingebiete S/D in den aktiven Bereichen AA des Halbleitersubstrats 1 vorzugsweise durch Ionenimplantation unter Verwendung der Wortleitungsstapel selbstjustierend ausgebildet, wobei üblicherweise symmetrische Übergänge verwendet werden. Unsymmetrische p/n-Übergänge können beispielsweise durch zusätzliche Maskierschritte realisiert werden.

Anschließend werden an den Seitenwänden der Wortleitungsstapel sogenannte Spacer 7 vorzugsweise aus Siliziumnitrid ausgebildet, wobei beispielsweise ein Abscheiden und anisotropes Zurückätzen einer Nitridschicht durchgeführt wird. Die Schutzschicht 6 sowie die Dicke der Spacer 7 ist hierbei derart ausgelegt, dass sie für die weiteren Prozessschritte einen ausreichenden Schutz darstellt.

Nach Entfernen der ersten Isolierschicht 2, die auch schon zu einem früheren Zeitpunkt entfernt werden kann, wird in einem nachfolgenden Herstellungsschritt eine zweite leitende Schicht 9 ganzflächig auf dem Wafer ausgebildet. Vorzugsweise wird hierfür eine LPCVD-Abscheidung (low pressure chemical vapor deposition) von insitu-dotiertem Polysilizium durchgeführt, wodurch die Zwischenräume zwischen den parallelen Wortleitungsstapeln vollständig und ohne Ausbilden von Lücken oder Hohlräumen (voids) aufgefüllt werden. Die zweite leitende Schicht 9 berührt hierbei unmittelbar an der Oberfläche des Halbleitersubstrats 1 die Source- und Draingebiete S/D, wobei insbesondere bei Verwendung von n⁺-insitu dotiertem Polysilizium der Übergang ein Ohmsches Verhalten erhält und beispielsweise bei einer thermischen Nachbehandlung das Halbleitersubstrat 1 bzw. die darin ausgebildeten Source- und Draingebiete S/D durch Ausdiffusion der Dotierstoffe aus dem Polysilizium der zweiten leitenden Schicht 9 weiter dotiert wird. Optional besteht auch die Möglichkeit die vorstehend beschriebene Ionenimplantation durch eine derartige Diffusion zu ersetzen, wobei die Source/Draingebiete unmittelbar durch Ausdiffusion von Dotierstoffen aus der zweiten leitenden Schicht 9 ausgebildet werden können.

In einem nachfolgenden Herstellungsschritt wird die zweite leitende Schicht 9 zum Freilegen der Schutzschicht 6 bzw. der Spacer 7 rückgebildet, wobei vorzugsweise ein chemisch-mechanisches Polieren (chemical mechanical polishing, CMP) der Polysiliziumschicht 9 bis zur Nitridschicht bzw. Schutzschicht 6 und der Spacer 7 erfolgt. In diesem Fall dient die Nitridschicht der Schutzschicht 6 und der Spacer 7 als Ätzstoppschicht und darüber hinaus als CMP-Detektionsschicht, mit der das Freilegen der Schutzschicht 6 zuverlässig erfasst werden kann und ein zu tiefes Polieren verhindert wird. Insbesondere bei Verwendung von hoch dotiertem Polysilizium für die zweite leitende Schicht 9 und Nitrid für die Schutzschicht 6 bzw. die Spacer 7 kann somit ein Rückbilden der zweiten leitenden Schicht 9 auf besonders einfache Art und Weise erfolgen.

Beispielsweise kann in einem nachfolgenden Schritt die zweite leitende Schicht 9 weiter zurückgebildet bzw. abgetragen werden, wobei ein anisotropes und/oder isotropes Ätzverfahren angewendet wird. Auf diese Weise können Kurzschlüsse zwischen der nunmehr streifenförmig ausgebildeten zweiten leitenden Schicht 9 zuverlässig verhindert werden. Gemäß Figur 3 ist nach diesem Herstellungsschritt der Raum zwischen jeweiligen Wortleitungsstapeln vollständig mit der zweiten leitenden Schicht 9 ausgefüllt.

Figur 4 zeigt eine Draufsicht der erfindungsgemäßen SNOR-Halbleiterschaltungsanordnung nach den vorstehend beschriebenen Herstellungsschritten, wobei gleiche Bezugszeichen gleiche Schichten bzw. Elemente wie in Figur 3 bezeichnen, weshalb auf eine wiederholte Beschreibung nachfolgend verzichtet wird.

Es sei an dieser Stelle darauf hingewiesen, dass ein nicht dargestellter Logikbereich zur Ansteuerung des Matrixfeldes von der ladungsspeichernden Schicht 3, der zweiten Isolierschicht 4, der ersten leitenden Schicht 5 und der Schutzschicht 6 vollständig bedeckt ist, wobei erst zu diesem Zeitpunkt dieser Schichtstapel vollständig entfernt wird und der gesamte logische Bereich bzw. dessen Schaltung ausgebildet wird. Die logischen Schaltungen können jedoch auch zu einem anderen Zeitpunkt im Logikbereich ausgebildet werden.

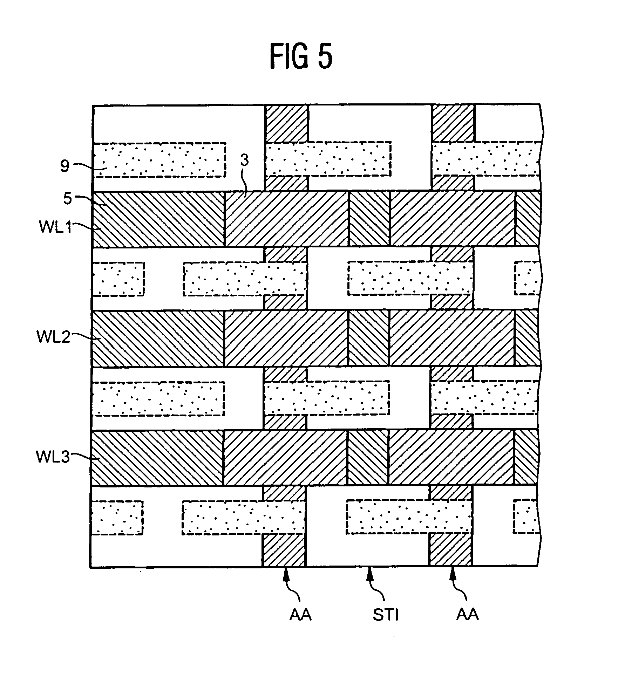

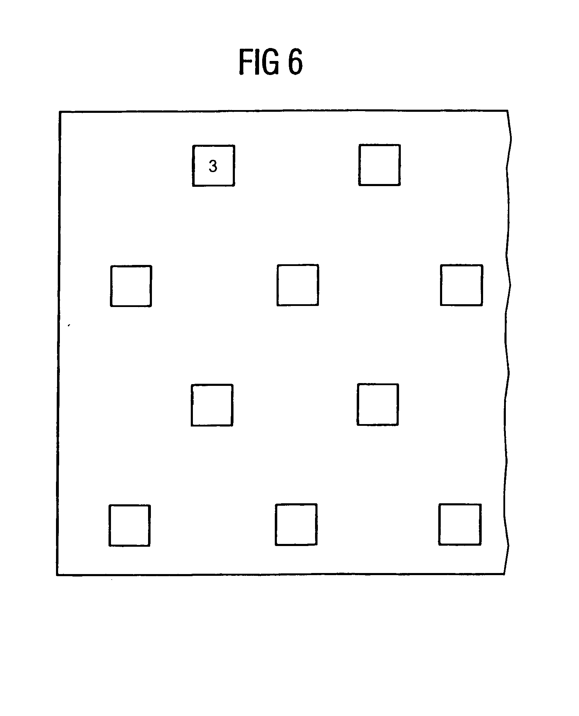

Figur 5 zeigt eine Draufsicht gemäß einem weiteren Herstellungsschritt der erfindungsgemäßen SNOR-Halbleiterschaltungsanordnung, wobei gleiche Bezugszeichen wiederum gleiche Schichten bzw. Elemente bezeichnen und auf eine wiederholte Beschreibung nachfolgend verzichtet wird. Zur Realisierung von einzelnen Streifenstücken bzw. Anschlussstreifen 9 wird mittels einer in Figur 6 dargestellten speziellen Maske die zweite leitende Schicht in regelmäßigen Abständen derart unterbrochen, dass zumindest ein Teil der Anschlussstreifen 9 unmittelbar die Oberfläche des Halbleitersubstrats an den Source- und Draingebieten (S/D) bzw. den aktiven Bereich AA berührt, während der restliche Teil über der Grabenisolierung STI liegt. Zum Entfernen dieser kleinen Streifenstücke wird vorzugsweise ein anisotropes Ätzen der zweiten leitenden Schicht 9 durchgeführt, wobei eine Verjustierung in diesem Maskenprozess relativ unproblematisch ist, da die Wortleitungsstapel mit der Schutzschicht 6 und den Spacern 7 bedeckt sind, die als Ätzstoppschicht wirken. Insbesondere bei Verwendung von Siliziumnitrid für die Schutzschicht 6 und den Spacer 7 erhält man auf besonders einfache Art und Weise ein selektives Ätzen der Polysiliziumbahnen bzw. zweiten leitenden Schicht 9, wobei auch größere Dejustierungen keine Probleme bereiten.

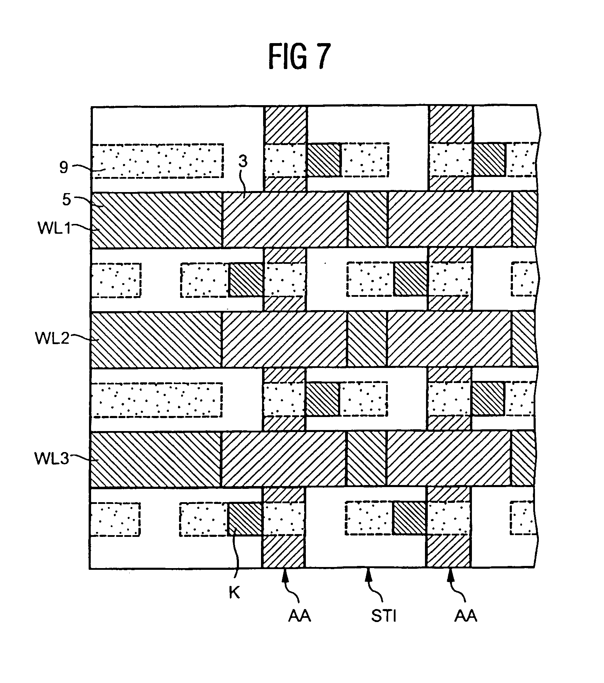

Anschließend erfolgt eine Ausbildung einer dritten Isolierschicht 11, die als zwischendielektrische Schicht (ILD, inter-layer dielectric) vorzugsweise aus fließfähigem BPSG (Bohr-Phosphor dotiertes Silikatglas) besteht. Auf diese Weise können die freigeätzten Lücken perfekt geschlossen bzw. aufgefüllt werden. Gemäß Figur 7 werden in einem nachfolgenden Herstellungsschritt im Wesentlichen oberhalb der Grabenisolierung STI und an den Stellen der Anschlussstreifen 9 Kontaktlöcher in der dritten Isolierschicht 11 freigeätzt und Kontakte K ausgebildet. Vorzugsweise wird für diese Kontakte K metallisches Material verwendet, wobei jedoch in gleicher Weise hoch dotiertes Polysilizium bzw. Halbleitermaterial verwendet werden kann. Wiederum ist eine Dejustierung beim Freilegen der Kontaktöffnungen sowie beim Abscheiden bzw. Ausbilden der eigentlichen Kontakte K unproblematisch, da die darunter liegende Schutzschicht 6 sowie die Spacer 7 der Wortleitungsstapel als zuverlässige Ätzstoppschicht wirken und darüber hinaus eine hohe Isolationsfähigkeit aufweisen. Für die Kontaktätzung erhält man insbesondere bei Verwendung von Siliziumnitrid und Polysilizium für die zweite leitende Schicht einen perfekten sogenannten "stopping liner". Die Anforderungen an ein Justiergenauigkeit sind daher sehr gering, wobei im Extremfall gemäß Figur 7 sogar sogenannte grenzlose Kontakte bzw. "borderless" Kontakte hergestellt werden können.

In einem nachfolgenden Metallisierungsschritt werden die Kontakte K mit einer ganzflächigen Metallisierungsschicht 10 bedeckt, die anschließend zum Ausbilden von im Wesentlichen geradlinigen Sourceleitungen SL1, SL2, ... und Drainleitungen DL1, DL2, ... strukturiert wird. Da die Kontakte K nunmehr ausreichend weit außerhalb des aktiven Bereichs AA liegen, kann auf die schwer herzustellenden mäanderförmigen Strukturen mit ihren Lithoartefakten verzichtet werden, wodurch man eine besonders einfache Lithografie (im wesentlichen geradlinig) für den gesamten Herstellungsprozess erhält. Darüber hinaus besitzt eine derartige gerade Struktur den weiteren Vorteil, dass sie eine maximale Integrationsdichte ermöglicht und die Verwendung von regelmäßigen Kontaktmasken begünstigt.

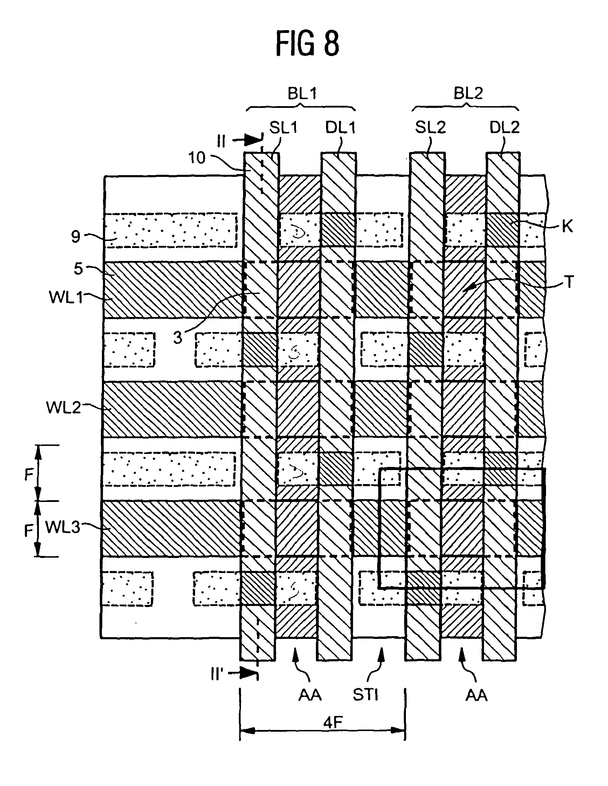

Da die zweite leitende Schicht 9 bzw. die Anschlussflächen nicht lithografisch ausgebildet werden, sondern sich durch Auffüllen von Zwischenbereichen ergeben, können sublithografische Strukturen erzeugt werden, die eine Zellfläche weiter verringern. Gemäß Figur 8 beträgt demzufolge eine Fläche für ein Schaltelement T 2F * 4F = 8F², wobei F eine kleinste lithografisch realisierbare Strukturbreite eines jeweiligen Verfahrens darstellt. Insbesondere auf Grund der Selektivität zur Schutzschicht 6 bei der Kontaktätzung und einem genügenden Überlappbereich des Anschlussstreifens 9 erhält man für die Kontakte K eine außerordentlich hohe Justiertoleranz, die sich in geringen Herstellungskosten und einer erhöhten Ausbeute niederschlägt.

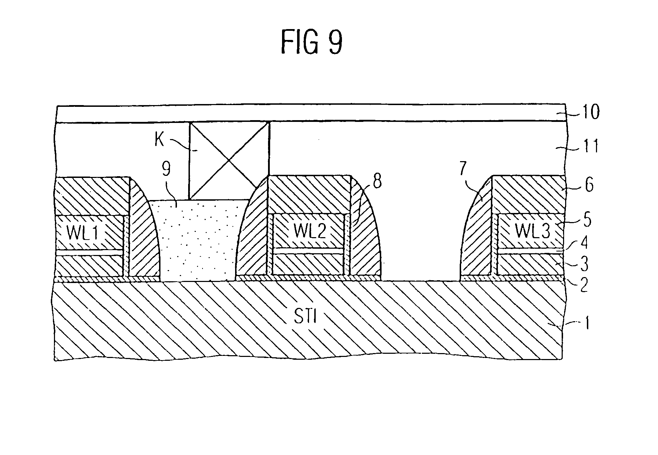

Figur 9 zeigt eine vereinfachte Schnittansicht der SNOR-Halbleiterschaltungsanordnung entlang eines Schnitts II-II' in Figur 8 wobei gleiche Bezugszeichen gleiche Schichten bzw. Elemente wie in den Figuren 3 bis 7 bezeichnen und auf eine wiederholte Beschreibung nachfolgend verzichtet wird.

Gemäß Figur 9 ist eine vorstehend beschriebene Dejustierung eines Kontaktes K dargestellt, wobei das Kontaktloch teilweise auf der Schutzschicht 6 und dem Spacer 7 eines Wortleitungsstapels liegt. Da jedoch diese Schicht bzw. der Spacer als Ätzstoppschicht auch für das Ausbilden des Kontaktlochs in der dritten Isolierschicht 11 wirkt, besteht keinerlei Gefahr, dass die Wortleitungen zerstört werden oder ein Kurzschluss erzeugt wird. Bereits minimale Berührungspunkte des Kontakts K mit der Source- bzw. Drainleitung 10 und/oder der zweiten leitenden Schicht 9 reichen für eine funktionsfähige Schaltungsanordnung aus.

Die Erfindung wurde vorstehend anhand von aus insitudotierten Polysilizium-Anschlussstreifen beschrieben. Sie ist jedoch nicht darauf beschränkt und umfasst in gleicher Weise Anschlussstreifen, die ein siliziertes Polysilizium aufweisen. Ferner können die Anschlussstreifen auch ein Metall aufweisen, wobei beispielsweise TiN, WN, TaN usw. verwendet werden können. In gleicher Weise kann auch für die Wortleitungen bzw. die erste leitende Schicht hochdotiertes Polysilizium, Polyzid, siliziertes Polysilizium und/oder ein Metall verwendet werden.

## Patentansprüche

1. Halbleiterschaltungsanordnung mit
einer Vielzahl von in einem Halbleitersubstrat (1) ausgebildeten matrixförmig angeordneten Schaltelementen (T);
einer Vielzahl von im Wesentlichen geraden Wortleitungen (WL1 bis WL3) aus einer ersten leitenden Schicht (5) zum zeilenweisen Ansteuern der Schaltelemente (T);
einer Vielzahl von im Wesentlichen geraden Bitleitungen (BL1, BL2) zum spaltenweisen Ansteuern der Schaltelemente (T);
wobei
die Wortleitungen (WL1 bis WL3) im Wesentlichen durch eine Steuerschicht (5) der Schaltelemente ausgebildet werden, und die Bitleitungen jeweils eine Sourceleitung (SL1) und eine Drainleitung (DL1) aufweisen, die eine selektive Ansteuerung von jeweiligen Source- und Draingebieten (S/D) des Schaltelements (T) ermöglichen, die in im Wesentlichen geraden aktiven Bereichen (AA) des Halbleitersubstrats (1) voneinander beabstandet ausgebildet sind; und
einer Vielzahl von zwischen den Wortleitungen (WL1 bis WL3) liegenden elektrisch leitenden Anschlusselementen (9) zum Anschließen der Source- und Draingebiete (S/D) an die jeweiligen Sourceleitungen (SL1) und Drainleitungen (DL1),
**dadurch gekennzeichnet, dass**
die Anschlusselemente (9) Anschlussstreifen aus einer zweiten leitenden Schicht darstellen, die unter den Bitleitungen ausgebildet sind, wobei zumindest ein Teil der Anschlussstreifen (9) unmittelbar die Oberfläche des Halbleitersubstrats (1) an den Source- und Draingebieten (S/D) berührt, während der restliche Teil über einer Grabenisolierung (STI) liegt.

2. Halbleiterschaltungsanordnung nach Patentanspruch 1,
**dadurch gekennzeichnet, dass** der Anschlussstreifen (9) insitu-dotiertes Polysilizium aufweist.

3. Halbleiterschaltungsanordnung nach Patentanspruch 1 oder 2,
**dadurch gekennzeichnet, dass** der Anschlussstreifen (9) ein siliziertes Polysilizium aufweist.

4. Halbleiterschaltungsanordnung nach Patentanspruch 1,
**dadurch gekennzeichnet, dass** der Anschlussstreifen (9) ein Metall aufweist.

5. Halbleiterschaltungsanordnung nach einem der Patentansprüche 1 bis 4,
**dadurch gekennzeichnet, dass** die Schaltelemente (T) nichtflüchtige Eintransistor-Speicherzellen mit
einer ersten Isolierschicht (2),
einer ladungsspeichernden Schicht (3),
einer zweiten Isolierschicht (4), und
einer Steuerschicht (5) aufweisen.

6. Halbleiterschaltungsanordnung nach einem der Patentansprüche 1 bis 5,
**dadurch gekennzeichnet, dass** die Wortleitungen (WL1 bis WL3) eine isolierende Schutzschicht (6, 7) aufweisen, die als Ätzstoppschicht und/oder CMP-Detektionsschicht wirkt.

7. Halbleiterschaltungsanordnung nach Patentanspruch 6,
**dadurch gekennzeichnet, dass** die isolierende Schutzschicht (6, 7) ein Siliziumnitrid aufweist.

8. Halbleiterschaltungsanordnung nach einem der Patentansprüche 1 bis 7,
**dadurch gekennzeichnet, dass** die aktiven Bereiche (AA) mittels flacher Grabenisolierung (STI) im Halbleitersubstrat (1) ausgebildet sind.

9. Verfahren zum Herstellen einer Halbleiterschaltungsanordnung mit den Schritten:
a) Ausbilden von im Wesentlichen geraden aktiven Bereichen (AA) in einem Halbleitersubstrat (1);
b) Ausbilden einer ersten Isolierschicht (2) und einer ladungsspeichernden Schicht (3);
c) Strukturieren der ladungsspeichernden Schicht (3);
d) Ausbilden einer zweiten Isolierschicht (4), einer ersten leitenden Schicht (5) und einer Schutzschicht (6);
e) Strukturieren der Schutzschicht (6), der ersten leitenden Schicht (5), der zweiten Isolierschicht (4) und der ladungsspeichernden Schicht (3) zum Ausbilden von im Wesentlichen geraden Wortleitungsstapeln;
f) Ausbilden von Source- und Draingebieten (S/D) im aktiven Bereich (AA) des Halbleitersubstrats (1) ;
g) Ausbilden von Spacern (7) an den Seitenwänden der Wortleitungsstapel und Entfernen der nicht bedeckten ersten Isolierschicht (2);
h) Ausbilden einer zweiten leitenden Schicht (9);
i) Rückbilden der zweiten leitenden Schicht (9) zum Freilegen der Schutzschicht (6);
j) Strukturieren der zweiten leitenden Schicht (9) zum Ausbilden von einzelnen Anschlussstreifen;
k) Ausbilden einer dritten Isolierschicht (11) und von darin befindlichen Source/Drain-Kontakten (K); und
l) Ausbilden von im Wesentlichen geraden Sourceleitungen (SL1) und Drainleitungen (DL1).

10. Verfahren nach Patentanspruch 9,
**dadurch gekennzeichnet, dass** in Schritt a) die aktiven Bereiche (AA) mittels flacher Grabenisolierung (STI) ausgebildet werden.

11. Verfahren nach Patentanspruch 9 oder 10,
**dadurch gekennzeichnet, dass** in Schritt b) die ladungsspeichernde Schicht (3) als elektrisch leitende und/oder elektrisch nicht leitende Einzel- oder Mehrfachschicht ausgebildet wird.

12. Verfahren nach einem der Patentansprüche 9 bis 11,
**dadurch gekennzeichnet, dass** in Schritt d) und g) eine Schutzschicht (6) und ein Spacer (7) ausgebildet wird, die als Rückbildungsschutzschicht und -erfassungsschicht wirken.

13. Verfahren nach Patentanspruch 12,
**dadurch gekennzeichnet, dass** eine Siliziumnitridschicht ausgebildet wird.

14. Verfahren nach einem der Patentansprüche 9 bis 13,
**dadurch gekennzeichnet, dass** in Schritt f) eine selbstjustierende Ionenimplantation durchgeführt wird.

15. Verfahren nach einem der Patentansprüche 9 bis 14,
**dadurch gekennzeichnet, dass** in Schritt h) eine insitu-dotierte Polysiliziumschicht ausgebildet wird.

16. Verfahren nach Patentanspruch 15,
**dadurch gekennzeichnet, dass** die insitu-dotierte Polysiliziumschicht mittels einer LPCVD-Abscheidung ausgebildet wird.

17. Verfahren nach einem der Patentansprüche 9 bis 16,
**dadurch gekennzeichnet, dass** in Schritt i) ein chemisch-mechanisches Polieren bis zur Schutzschicht (6) durchgeführt wird.

18. Verfahren nach Patentanspruch 17,
**dadurch gekennzeichnet, dass** ein weiteres Rückätzen der zweiten leitenden Schicht (9) durchgeführt wird.

19. Verfahren nach einem der Patentansprüche 9 bis 18,
**dadurch gekennzeichnet, dass** in Schritt k) eine BPSG-Schicht als dritte Isolierschicht (11) ausgebildet wird.

## Claims

1. Semiconductor circuit arrangement having
a multiplicity of switching elements (T) which are formed in a semiconductor substrate (1) and are arranged in matrix-type fashion;
a multiplicity of essentially straight word lines (WL1 to WL3) from a first conductive layer (5) for row by row driving of the switching elements (T);
a multiplicity of essentially straight bit lines (BL1, BL2) for column by column driving of the switching elements (T);
the word lines (WL1 to WL3) essentially being formed by a control layer (5) of the switching elements and the bit lines each having a source line (SL1) and a drain line (DL1), which enable a selective driving of the respective source and drain regions (S/D) of the switching element (T) which are formed in a manner spaced apart from one another in essentially straight active regions (AA) of the semiconductor substrate (1); and
a multiplicity of electrically conductive connection elements (9), which are located between the word lines (WL1 to WL3) and serve for connecting the source and drain regions (S/D) to the respective source lines (SL1) and drain lines (DL1),
**characterized in that**
the connection elements (9) constitute connection strips from a second conductive layer which are constructed under the bit lines, at least a portion of the connection strips (9) directly making contact with the surface of the semiconductor substrate (1) at the source and drain regions (S/D), while the remaining portion lies above a trench isolation (STI).

2. Semiconductor circuit arrangement according to Patent Claim 1,
**characterized in that** the connection strip (9) has in-situ-doped polysilicon.

3. Semiconductor circuit arrangement according to Patent Claim 1 or 2,
**characterized in that** the connection strip (9) has a siliconized polysilicon.

4. Semiconductor circuit arrangement according to Patent Claim 1,
**characterized in that** the connection strip (9) has a metal.

5. Semiconductor circuit arrangement according to one of Patent Claims 1 to 4,
**characterized in that** the switching elements (T) have nonvolatile one-transistor memory cells having
a first insulating layer (2),
a charge-storing layer (3),
a second insulating layer (4), and
a control layer (5).

6. Semiconductor circuit arrangement according to one
of Patent Claims 1 to 5,
**characterized in that** the word lines (WL1 to WL3) have an insulating protective layer (6, 7), which acts as an etching stop layer and/or CMP detection layer.

7. Semiconductor circuit arrangement according to Patent Claim 6,
**characterized in that** the insulating protective layer (6, 7) has a silicon nitride.

8. Semiconductor circuit arrangement according to one of Patent Claims 1 to 7,
**characterized in that** the active regions (AA) are formed by means of shallow trench isolation (STI) in the semiconductor substrate (1).

9. Method for fabricating a semiconductor circuit arrangement having the following steps:
a) formation of essentially straight active regions (AA) in a semiconductor substrate (1);
b) formation of a first insulating layer (2) and a charge-storing layer (3);
c) patterning of the charge-storing layer (3);
d) formation of a second insulating layer (4), a first conductive layer (5) and a protective layer (6);
e) patterning of the protective layer (6), the first conductive layer (5), the second insulating layer (4) and the charge-storing layer (3) for the purpose of forming essentially straight word line stacks;
f) formation of source and drain regions (S/D) in the active region (AA) of the semiconductor substrate (1);
g) formation of spacers (7) on the sidewalls of the word line stacks and removal of the non-covered first insulating layer (2);
h) formation of a second conductive layer (9);
i) back formation of the second conductive layer (9) for the purpose of uncovering the protective layer (6);
j) patterning of the second conductive layer (9) for the purpose of forming individual connection strips;
k) formation of a third insulating layer (11) and source/drain contacts (k) situated therein; and
l) formation of essentially straight source lines (SL1) and drain lines (DL1).

10. Method according to Patent Claim 9,
**characterized in that**, in step a), the active regions (AA) are formed by means of shallow trench isolation (STI).

11. Method according to Patent Claim 9 or 10,
**characterized in that**, in step b), the charge-storing layer (3) is formed as an electrically conductive and/or electrically nonconductive individual layer or multilayer.

12. Method according to one of Patent Claims 9 to 11,
**characterized in that**, in steps d) and g), a protective layer (6) and a spacer (7) are formed, which act as back-formation protective layer and detection layer.

13. Method according to Patent Claim 12,
**characterized in that** a silicon nitride layer is formed.

14. Method according to one of Patent Claims 9 to 13,
**characterized in that**, in step f), a self-aligning ion implantation is carried out.

15. Method according to one of Patent Claims 9 to 14,
**characterized in that**, in step h), an in-situ-doped polysilicon layer is formed.

16. Method according to Patent Claim 15,
**characterized in that** the in-situ-doped polysilicon layer is formed by means of an LPCVD deposition.

17. Method according to one of Patent Claims 9 to 16,
**characterized in that**, in step i), a chemical mechanical polishing is carried out as far as the protective layer (6).

18. Method according to Patent Claim 17,
**characterized in that** a further etching-back of the second conductive layer (9) is carried out.

19. Method according to one of Patent Claims 9 to 18,
**characterized in that**, in step k), a BPSG layer is formed as third insulating layer (11).

## Revendications

1. Montage à semiconducteur comprenant
une pluralité d'éléments (T) de commutation disposés sous forme de matrice et constitués dans un substrat (1) semiconducteur ;
une pluralité de lignes (WL1 à WL3) de mot sensiblement rectilignes, constituées d'une première couche (5) conductrice pour commander ligne par ligne les éléments (T) de commutation;
une pluralité de lignes (BL1, BL2) de bits sensiblement rectilignes pour commander colonne par colonne les éléments (T) de commutation, dans lequel
les lignes (WL1 à WL3) de mots sont constituées essentiellement par une couche (5) de commande des éléments de commutation et les lignes de bits ont respectivement une ligne (SL1) de source et une ligne (DL1) de drain, qui permettent une commande sélective des zones (S/D) de source et de drain respectives de l'élément (T) de commutation qui sont formées en étant à distance l'une de l'autre dans des parties (AA) actives sensiblement rectilignes du substrat (1) semiconducteur ; et
une pluralité d'éléments (9) de connexion conducteurs de l'électricité interposés entre les lignes (WL1 à WL3) de mots pour relier les zones (S/D) de source et de drain aux lignes (SL1) de source et aux lignes (DL1) de drain respectives,
**caractérisé en ce que** les éléments (9) de connexion constituent des bandes de connexion en une deuxième couche conductrice, qui sont constituées sous les lignes de bits, au moins une partie des bandes (9) de connexion touchant directement la surface du substrat (1) semiconducteur aux zones (S/D) de source et de drain , tandis que la partie restante se trouve sur un isolement (STI) à sillon.

2. Montage à semiconducteur suivant la revendication 1,
**caractérisé en ce que** la bande (9) de connexion a du polysilicium dopé in situ.

3. Montage à semiconducteur suivant la revendication 1 ou 2,
**caractérisé en ce que** la bande (9) de connexion a du polysilicium silicié.

4. Montage à semiconducteur suivant la revendication 1,
**caractérisé en ce que** la bande (9) de connexion a un étage.

5. Montage à semiconducteur suivant l'une des revendications 1 à 4,
**caractérisé en ce que** les éléments (T) de commutation ont des cellules de mémoire à un seul transistor non volatil comprenant
une première couche (2) isolante,
une couche (3) d'emmagasinage de charge,
une deuxième couche (4) isolante, et
une couche (5) de commande.

6. Montage à semiconducteur suivant l'une des revendications 1 à 5,
**caractérisé en ce que** les lignes (WL1 à WL3) de mots ont une couche (6, 7) de protection isolante qui sert de couche d'arrêt d'attaque et/ou de couche de détection de CMP.

7. Montage à semiconducteur la revendication 6,
**caractérisé en ce que** la couche (6, 7) de protection isolante a un nitrure de silicium.

8. Montage à semiconducteur suivant l'une des revendications 1 à 7,
**caractérisé en ce que** les parties (AA) actives sont constituées dans le substrat (1) semiconducteur au moyen d'un isolement (STI) plat à sillon.

9. Procédé de production d'un montage à semiconducteur comprenant les stades dans lesquels :
a) on forme des parties (AA) actives sensiblement rectilignes dans un substrat (1) semiconducteur,
b) on forme une première couche (2) isolante et une couche (3) d'emmagasinage de charge,
c) on structure la couche (3) d'emmagasinage de charge,
d) on forme une deuxième couche (4) isolante, une première couche (5) conductrice et une couche (6) de protection,
e) on structure la couche (6) de protection, la première couche (5) conductrice, la deuxième couche (4) isolante et la couche (3) d'emmagasinage de charge pour former des piles de lignes de mots sensiblement rectilignes,
f) on forme des zones (S/D) de source et de drain dans la partie (AA) active du substrat (1) semiconducteur,
g) on forme des espaceurs (7) sur les parois latérales des piles de lignes de mots et on élimine la première couche (2) isolante non revêtue,
h) on forme une deuxième couche (9) conductrice,
i) on forme en retrait la deuxième couche (9) conductrice pour mettre à nu la couche (6) de protection,
j) on structure la deuxième couche (9) conductrice pour former des bandes de connexion individuelle,
k) on forme une troisième couche (11) isolante et des contacts (K) de source/drain qui s'y trouvent, et
l) on forme des lignes (SL1) de source et des lignes (DL1) de drain sensiblement rectilignes.

10. Procédé suivant la revendication 9,
**caractérisé en ce qu'**au stade a) on forme les parties (AA) actives au moyen d'un isolement (STI) à sillon plat.

11. Procédé suivant la revendication 9 ou 10,
**caractérisé en ce qu'**au stade b) on forme la couche (3) d'emmagasinage de charge en tant que couche individuelle ou multiple conductrice de l'électricité et/ou non conductrice de l'électricité.

12. Procédé suivant l'une des revendications 9 à 11,
**caractérisé en ce qu'**au stade d) et g) on forme une couche (6) de protection et un espaceur (7) qui agissent en tant que couche de protection de formation en retrait et de couche de détection.

13. Procédé suivant la revendication 12, **caractérisé en ce qu'**on forme une couche en nitrure de silicium.

14. Procédé suivant l'une des revendications 9 à 13,
**caractérisé en ce qu'**au stade f) on effectue une implantation d'ions à auto-alignement.

15. Procédé suivant l'une des revendications 9 à 14,
**caractérisé en ce qu'**au stade h) on forme une couche de polysilicium dopé in situ.

16. Procédé suivant la revendication 15,
**caractérisé en ce qu'**on forme la couche de polysilicium dopé in situ au moyen d'un dépôt LPCVD.

17. Procédé suivant l'une des revendications 9 à 16,
**caractérisé en ce qu'**au stade i) on effectue un polissage chemiomécanique jusqu'à la couche (6) de protection.

18. Procédé suivant la revendication 17,
**caractérisé en ce qu'**on effectue une attaque en retrait supplémentaire de la deuxième couche (9) conductrice.

19. Procédé suivant l'une des revendications 9 à 18,
**caractérisé en ce qu'**au stade k) on forme une couche de BPSG en tant que troisième couche (11) isolante.
